Europäisches Patentamt

European Patent Office

Office européen des brevets

(11) Veröffentlichungsnummer: **0 394 507**

**A1**

(12) **EUROPÄISCHE PATENTANMELDUNG**

(21) Anmeldenummer: **89107376.9**

(51) Int. Cl.5: **G11C 27/02**

(22) Anmeldetag: **24.04.89**

(43) Veröffentlichungstag der Anmeldung:
**31.10.90 Patentblatt 90/44**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Astegher, Berthold**
**Hauptplatz 7**
**A-9500 Villach(AT)**
Erfinder: **Jessner, Hermann**
**Neubaugasse 28/5**
**A-9500 Villach(AT)**
Erfinder: **Lechner, Alexander**
**Dietrichsteinstrasse 27**
**A-9583 Faak/See(AT)**

(54) Schnelle Abtast-Halte-Schaltungsanordnung.

(57) Zur Realisierung einer Abtast-Halte-Schaltungsanordnung für differenzielle Signale mit geringer Haltekapazität wird ein Verstärker angegeben, bei dem im Kollektorkreis und im Emitterkreis die gleichen Stromverhältnisse herrschen, indem die Basisströme über zusätzliche Transistoren abgezogen werden und somit in den Kollektor- und Emitterwiderständen die gleichen Ströme fließen und gleiche Spannungsverhältnisse herrschen, indem in den Kollektorkreis jeweils eine zusätzliche Diode geschaltet wird.

FIG 7

EP 0 394 507 A1

## Schnelle Abtast-Halte-Schaltungsanordnung

Die Erfindung betrifft eine Schaltungsanordnung nach dem Oberbegriff des Patentanspruchs 1.

Abtast-Halte-Schaltungen (Sample & Holde bzw. Track & Hold) werden vor allem für Analog-Digital-Umsetzer benötigt, um für die Dauer des Umsetzvorganges einer analogen Eingangsspannung zu einem digitalen Ausgangswort die Eingangsspannung konstant zu halten und somit Fehler auszuschließen. Eine Abtast-Halte-Schaltung (S/H) tastet also ein analoges Spannungssignal zu bestimmten Zeitpunkten ab und hält den momentanen Spannungswert während der Haltephase in analoger Form konstant.

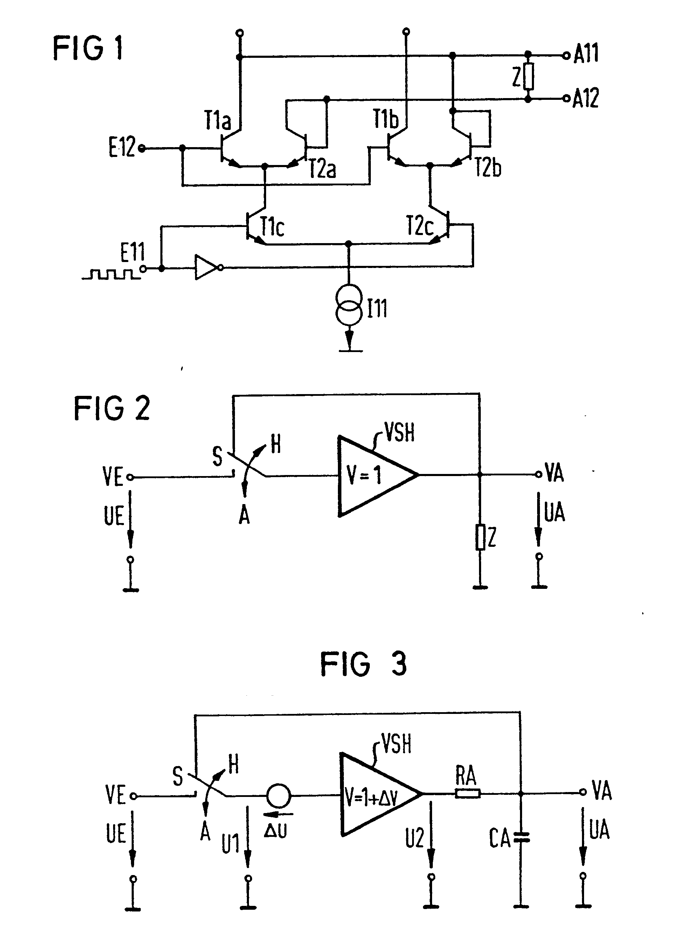

Aus der Veröffentlichung von Tanaka et. al. "A 40 MS/s Monolithic S/H IC", ISSCC 83 p. 190 ist eine Abtast-Halte-Schaltung bekannt, deren Prinzip in Fig. 1 wiedergegeben ist. Ein über einen Schalter S mit einer Eingangsklemme VE verbundener Kondensator C wird bei geschlossenem Schalter, Stellung A, auf eine Spannung aufgeladen, die proportional oder gleich der Eingangsspannung UE ist. Während der Haltephase, Stellung H des Schalters S, wird die Spannung am Kondensator C mit Hilfe des Verstärkers VSH hochohmig abgefühlt und steht an der Ausgangsklemme VA des Verstärkers, bezogen auf eine Bezugsklemme, als Ausgangsspannung UA zur Verfügung.

Der Schalter S muß von einem möglichst niederohmigen Zustand während der Abtastphase A, um den Kondensator C rasch umladen zu können, in einen möglichst hochohmigen Zustand während der Haltephase H umgeschaltet werden um den mit Hilfe des Kondensators C gespeicherten Spannungswert nicht zu beeinflussen. Ausführungen von Abtast-Halte-Schaltungen arbeiten im Frequenzbereich bis ca. 10 MHz mit Feldeffekt-Transistoren.

Schnellere Abtast-Halte-Verstärker erfordern aufwendige Schaltungen mit Feldeffekt- und Bipolartransistoren beider Leitungstypen und sind in monolithisch integrierter Form kaum bekannt. Der integrierte Schaltkreis gemäß der vorgenannten Veröffentlichung arbeitet bis zu einer Abtastfrequenz von 40 MHz.

Während der Haltephase tritt bei Abtast-Halte-Schaltungen das Problem auf, daß die Spannung, die von einem Kondensator gehalten wird, mit Hilfe eines Verstärkers gefühlt wird und hierbei über den endlichen Eingangswiderstand dieses Verstärkers Ladungen abfließen, was zu einem Absenken der über dem Kondensator anliegenden Spannung führt. Um einen störungsfreien Betrieb zu gewährleisten, ist also als Haltekapazität eine Kapazität erforderlich, die nicht allzu klein sein darf und somit die Arbeitsgeschwindigkeit der AbtastHalte-Schaltung begrenzt.

Aus dem Artikel "Applications of a Four-quadrant-multiplier" von C.R. Ryan in IEEE journal of Solid State Circuits, Feb. 1970, Seiten 45-48 ist eine Abtast-Halte-Schaltung bekannt, bei der die Verstärkungsabweichung eines rückgekoppelten Verstärkers die Haltezeit beeinflußt.

FIG 2 zeigt eine solche bekannte Schaltung mit einem Signaleingang, einem Steuereingang und einer Rückkoppelschaltung.

Aus der US-A-3,452,289 ist eine Signalverarbeitungseinheit bekannt, die folgende Kombination enthält: Einen ersten Differenzverstärker mit einem ersten und einem zweiten Halbleiterbauelement (beispielsweise einem fünften und sechsten Transistor T1c, T2c mit zusammengeschalteten Emittern, wobei jedes dieser Halbleiterbauelemente einen Steuereingang zum Empfangen eines ersten Eingangssignales sowie einen Kollektoranschluß aufweist, einen zweiten und einen dritten Differenzverstärker, die jeweils aus einem dritten und einem vierten bzw. einem fünften und einem sechsten Halbleiterbauelement (beispielsweise einem ersten, zweiten, dritten und vierten Transistor T1a, T1b, T2a, T2b) bestehen, wobei jedes Halbleiterbauelement einen Kollektor aufweist, einen Steuereingang besitzt und einen Emitter aufweist, wobei die Emitteranschlüsse der Transistoren in dem zweiten und im dritten Differenzverstärker jeweils zusammengeschaltet sind und jeweils an den Kollektor des ersten bzw. des zweiten Halbleiterbauelementes T1c, T2c angeschlossen sind, die Steuereingänge des dritten und des fünften Halbleiterbauelementes T1a, T1b sind zum Empfangen eines zweiten Eingangssignales zusammengeschaltet, die Kollektoranschlüsse des dritten und des sechsten Halbleiterbauelementes T1a, T2b sind zusammengeschaltet und bilden eine erste Ausgangsklemme A11, die Kollektoranschlüsse des vierten und des fünften Halbleiterbauelementes T2a, T1b sind ebenfalls zusammengeschaltet und bilden eine zweite Ausgangsklemme A12, die erste Ausgangsklemme A11 ist über Schaltmittel Z mit der zweiten Ausgangsklemme A12 verbunden und die erste Ausgangsklemme A11 ist an den Steuereinang des sechsten Halbleiterbauelements T2b geschaltet und die zweite Ausgangsklemme A12 ist an den Steuereingang des vierten Halbleiterbauelementes T2a geschaltet und die Steuereingänge des ersten und des zweiten Halbleiterbauelementes T1c, T2c sind derart mit dem ersten Eingangssignal E11 beaufschlagt, daß diese beiden Halbleiterbauelemente alternierend einen Strom leiten oder sperren.

Figur 1 zeigt eine solche bekannte Schaltung.

Bei solchen bekannten Schaltungen wird zwischen der Abtast- und der Halte-Phase dadurch umgeschaltet, daß der Strom in den einzelnen Strompfaden der Abtast-Halte-Verstärkerschaltung umgeschaltet wird, d.h. daß der Strom durch den in der Abtastphase aktivierten Strompfad abgeschaltet wird und der Strom durch den anderen, in der Haltephase aktivierten Strompfad eingeschaltet wird. Wie nachstehend noch erläutert wird ist es bei solchen Schaltungen besonders wichtig, daß der Verstärkungsfaktor des Abtast-Halte-Verstärkers möglich konstant ist und möglichst gleich 1 ist.

Aufgabe der Erfindung ist es, ein Abtast-Halte-Glied zum Verarbeiten differentieller Signale anzugeben, bei dem ein Verstärkungsfaktor von 1 einstellbar ist.

Diese Aufgabe wird erfindungsgemäß durch eine Schaltungsanordnung nach dem Patentanspruch 1 gelöst.

Die erfindungsgemäße Schaltungsanordnung besitzt den Vorteil, daß zur Speicherung der abgetasteten Analogspannung metastabile Zustände des Verstärkers ausgenutzt werden, so daß die Schaltungsanordnung im Idealfall ohne weiteres Stabilisierungsnetzwerk betrieben werden kann.

Um die Erfindung näher zu erläutern, wird im Folgenden vorab das Grundprinzip der in erfindungsgemäßen Schaltungen verwendeten Abtast-Halte-Schaltungen anhand von in den Figuren 1 bis 6 der Zeichnung dargestellten Ausführungsbeispielen näher erläutert. Dabei sind gleiche Elemente mit gleichen Bezugszeichen versehen. Es zeigt:

Figur 1 ein Schaltbild einer bekannten Abtast-Halte-Schaltung,

Figur 2 ein schematisches Schaltbild einer bekannten, für erfindungsgemäße Schaltungen wichtigen Abtast-Halte-Schaltung,

Figur 3 ein schematisches Ersatzschaltbild einer Abtast-Halte-Schaltungsanordnung gemäß Figur 2 unter Berücksichtigung physikalischer Störgrößen,

Figur 4 eine Abtast-Halte-Schaltungsanordnung gemäß Figur 3 mit umschaltbaren Ausgangszeitkonstanten,

Figur 5 und Figur 6 zwei Diagramme zur Abschätzung der Genauigkeitsanforderungen an eine Abtast-Halte-Schaltungsanordnung.

Figur 7 eine erfindungsgemäße Abtast-Halte-Schaltungsanordnung

Die Schaltungsanordnung gemäß Figur 2 nutzt metastabile Zustände des Verstärkers VSH aus, um eine mit Hilfe des Schalters S abgetastete analoge Eingangsspannung UE für eine bestimmte Zeitdauer bzw. während der Haltephase H konstant zu halten. Dabei liegt der Schalter 5 verstärkerseitig nur am Eingang des Verstärkers VSH, dessen Verstärkung V genau 1 betragen muß. Während der Haltephase H wird der Verstärkerausgang bzw. die Aus gangsklemme VA über den Schalter S direkt auf den Verstärkereingang rückgekoppelt.

Gemäß dem Ausführungsbeispiel nach Figur 2 ist von der Ausgangsklemme VA zur nichtbezeichneten Bezugsklemme ein komplexes Stabilisierungsnetzwerk Z vorgesehen, das im einfachsten Fall aus einem Kondensator bestehen kann. Bei idealen Bedingungen für die Abtast-Halte-Schaltungsanordnung kann das komplexe Stabilisierungsnetzwerk Z weggelassen werden, ohne daß sich die Ausgangsspannung UA in der Haltephase verändern würde. Unter Berücksichtigung realer physikalischer Verhältnisse muß für den Verstärker VSH ein Offset $\Delta u$ und eine Abweichung des Verstärkungsfaktors V vom Idealwert 1 um den Wert $\Delta v$ berücksichtigt werden. Figur 3 zeigt das physikalische Ersatzschaltbild der realen Abtast-Halte-Schaltungsanordnung gemäß Figur 2. Der Offset des Verstärkers VSH ist als Spannungsquelle mit der Spannung $\Delta u$ zwischen dem Schalter S und dem Eingang des Verstärkers VSH eingezeichnet.

Die Verstärkung V des Verstärkers VSH beträgt gemäß Figur 3 dann $1 + \Delta v$. Der real von 0 verschiedene Ausgangswiderstand des Verstärkers VSH ist als Widerstand RA zwischen dem Ausgang des Verstärkersymbols und der Ausgangsklemme VA eingezeichnet.

Im Ausführungsbeispiel gemäß Figur 3 ist für das Stabilisierungsnetzwerk Z zwischen der Ausgangsklemme VA der Schaltungsanordnung und demem Bezugspotential ein Stabilisierungskondensator CA vorgesehen. Entsprechend Figur 2 ist die Ausgangsklemme VA mit dem Schalter S verbunden und somit während der Haltephase H auf den Verstärkereingang rückgekoppelt.

Während der Abtastphase ist unter der Annahme, daß die Störgrößen $\Delta u$ und $\Delta v$ gleich Null sind, die 3 dB-Grenz-Kreisfrequenz gleich dem reziproken Produkt aus dem Ausgangswiderstand RA und dem Kondensator CA.

Das Verhalten der Schaltungsanordnung gemäß Figur 3 während der Haltephase, insbesondere die Dauer der metastabilen Zustände läßt sich unter Einführung der Spannungen U1 vom verstärkerseitigen Anschluß des Schalters S und U2 zwischen dem Verstärker VSH und dem Ausgangswiderstand RA, jeweils bezogen auf eine Klemme mit Bezugspotential, gemäß folgender Formeln berechnen:

$$U2 = (U1 + \Delta u) \cdot (1 + \Delta v)$$

$$\frac{dUA}{dt} = \frac{1}{CA} \cdot i_c(t) = \frac{U2(t)}{RA} - \frac{UA(t)}{CA}$$

$$U1 = UA$$

Damit ergibt sich folgende Differentialgleichung:

$$\frac{dUA}{dt} - \frac{\Delta v}{RA \; CA} \cdot UA = \frac{\Delta u}{RA \; CA} \cdot (1 + \Delta v).$$

Die allgemeine Lösung der Differentialgleichung lautet:

$$UA(t) = (UAo + \Delta u \cdot \frac{1 + \Delta v}{\Delta v} Y) \cdot \exp(\frac{\Delta v \cdot t}{RA \; CA}) - \Delta u \frac{1 + \Delta v}{\Delta v}$$

wobei UAo der Spannungswert zu Beginn der Haltephase ist.

Vereinfachte Lösungen der allgemeinen Lösung der Differentialgleichung gibt es für die Spezialfälle, daß jeweils eine der Störgrößen $\Delta u$ bzw. $\Delta v$ gleich Null sind. Man erhält für $\Delta u$ gleich Null:

$$UA(t) = UAo \cdot \exp(\frac{\Delta v \cdot t}{RA \cdot CA})$$

sowie für den Spezialfall v gleich Null:

$$UA(t) = UAo + \frac{u \cdot t}{RA \cdot CA}$$

Aus den vereinfachten Lösungen der Differantialgleichung ist zu erkennen, daß der metastabile Zustand der Abtast-Halte-Schaltungsanordnung um so schneller verlassen wird, je größer die Störgrößen $\Delta u$ und $\Delta v$ sind. Für den Fall $\Delta u$ gleich Null ergibt sich eine exponentielle Änderung der Ausgangsspannung UA mit zunehmender Zeit t, während für den Fall $\Delta v$ gleich Null zum Spannungswert zu Beginn der Abtastphase ein mit der Zeit linear wachsender additiver Term hinzukommt.

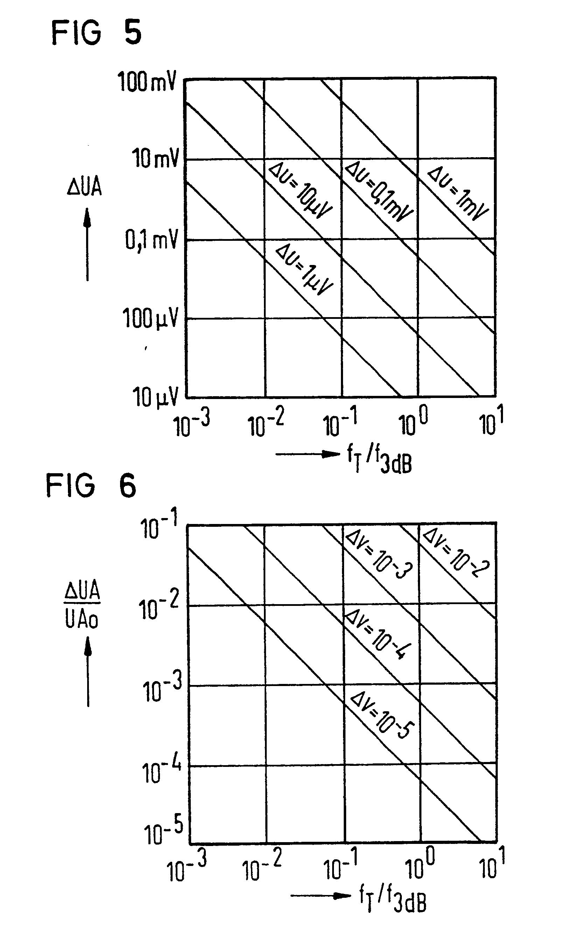

Im Ausführungsbeispiel gemäß Figur 4 ist am Ausgang des Verstärkers VSH ein zusätzlicher Schalter SA vorgesehen, der je nach Stellung einen Ausgangswiderstand RAH oder einen Ausgangswiderstand RAS in den Signalweg schaltet, wobei RAH größer als RAS gewählt wird. Damit wird die Ausgangszeitkonstante RAH·CA für die Haltephase größer als jene für die Abtastphase.

Die an eine erfindungsgemäße Abtast-Halte-Schaltungsanordnung zu stellenden Genauigkeitsanforderungen sind in den Diagrammen gemäß Figur 5 und Figur 6 dargestellt. In beiden Diagrammen ist auf der Abszisse die Abtastfrequenz $f_T$ bezogen auf die 3 dB-Grenzfrequenz abgetragen. Fig. 5 gibt als Ordinatenwert die Änderung $\Delta UA$ der Ausgangsspannung als Differenz des Wertes UAo der Ausgangsspannung zu Beginn der Haltephase und des Spannungswertes UA(T) nach der Zeit (T) an, die gleich der inversen Abtastfrequenz $f_T$ ist.

Als Parameter sind in Figur 5 dekadisch unterschiedliche Werte für die Störgröße $\Delta u$ eingetragen. Figur 6 zeigt auf der Ordinate die oben definierte Änderung $\Delta UA$ der Ausgangsspannung als Relativgröße, bezogen auf den Wert UAo der Ausgangsspannung zu Beginn der Haltephase und als Parameter verschiedene dekadisch gestufte Werte für die Störgröße $\Delta v$ in der Abweichung des Verstärkungsfaktors des Verstärkers VSH vom Idealwert 1.

Aus den Figuren 5 und 6 ist zu entnehmen, daß bei Störgrößen $\Delta u$ und $\Delta v$, die mit hochpräzisen monolithisch integrierten Verstärkern erreicht werden können, bei einer Abtastfrequenz $f_T$, die etwa der 3 dB-Grenzfrequenz entspricht, d.h. um den Abszissenwert $10^0$, noch eine hohe Genauigkeit der erfindungsgemäßen Abtast-Halte-Schaltungsanordnung zu erzielen ist. Die erreichbare Genauigkeit kann durch die Wahl unterschiedlicher Zeitkonstanten für die Abtast- bzw. Haltephase gemäß dem Schaltungsbeispiel nach Figur 4 weiter erhöht werden. Damit besitzt eine sol che erfindungsgemäße Abtast-Halte-Schaltungsanordnung den Vorteil, daß sie sich sogar für den Einsatz in monolithischen Analog-Digital-Umsetzern eignet, die nahe der Nyquistfrequenz betrieben werden.

Wenn, wie aus den vorherigen Erläuterungen zu entnehmen ist, der Verstärkungsfaktor eines erfindungsgemäßen Abtast-Halte-Verstärkers möglichst genau 1 ist, kann eine solche Schaltung mit einer geringen Haltekapazität Ch auskommen, was zu einer sehr hohen Verarbeitungsfrequenz führt.

Ein solcher Verstärker wird dadurch erreicht, daß im Kollektorkreis und im Emitterkreis jeweils das gleiche Strom- und Spannungsverhalten erzielt wird.

Figur 7 zeigt eine erfindungsgemäße Schaltungsanordnung, die eine Realisierung des Verstärkungsfaktors 1 ermöglicht mit einem symmetrisch aufgebauten AbtastHalte-Verstärker AHV, bestehend aus einem ersten Transistor T1a, einem zweiten Transistor T1b, einem dritten Transistor T2a und einem vierten Transistor T2b, wobei der Kollektor des ersten Transistors T1a mit dem Kollektor des dritten Transistors T2a zusammengeschaltet ist und die erste Ausgangsklemme Aa bildet und der Kollektor des zweiten Transistors T1b mit dem Kollektor des vierten Transistors T2b zusammengeschaltet ist und die zweite Ausgangsklemme Ab bildet, wobei die erste Ausgangsklemme Aa über einen ersten Kollektorwiderstand RCa an ein erstes Versorgungspotential $V_{CC}$ geschaltet ist und die zweite Ausgangsklemme Ab über einen zweiten Kollektorwiderstand RCb ebenfalls an dieses erste Versorgungspotential $V_{CC}$ geschaltet ist, wobei die erste Ausgangsklemme Aa mit den Steuereingang des vierten Transistors T2b verbunden ist und die zweite Ausgangsklemme Ab mit dem Steuereingang des dritten Transistors T2a verbunden ist, wobei der Steuereingang des ersten Transistors T1a eine erste Eingangsklemme Ea der Abtast-Halte-Schaltungsanordnung bildet, wobei der Steuereingang des zweiten Transistors T1b eine zweite Eingangsklemme Eb der Abtast-Halte-Schaltungsanordnung bildet, und diese bei den Eingangsklemmen Ea,Eb mit einem differenziellen Signal beaufschlagbar sind, wobei die erste und die zweite Ausgangsklemme Aa, Ab über eine Haltekapazität Ch miteinander verbunden sind, wobei die Emitter des ersten und des zweiten Transistors T1a, T1b und die Emitter des dritten und des vierten Transistors T2a, T2b jeweils über mindestens einen Widerstand REa, REb bzw. REc, REd miteinander verbunden sind, wobei der Emitterkreis des ersten Transistors T1a und der Emitterkreis des zweiten Transistors T1b gemeinsam an den Kollektoranschluß eines fünften Transistors TS geschaltet sind und der Emitterkreis des dritten Transistors T2a sowie der Emitterkreis des vierten Transistors T2b gemeinsam an den Kollektoranschluß eines sechsten Transistors TH geschaltet sind, wobei der Emitteranschluß des fünften Transistors TS gemeinsam mit dem Emitteranschluß des sechsten Transistors TH über eine Konstantstromeinprägung Ik1 an das zweite Versorgungspotential $V_{EE}$ geschaltet ist und wobei der Steuereingang ES des fünften Transistors TS und der Steuereingang EH des sechsten Transistors TH derart mit einem Signal beaufschlagt sind, daß der fünfte und der sechste Transistor TS, TH alternierend einen Strom leiten oder sperren die sich von Schaltungen nach FIG 1 unter anderem dadurch unterscheidet, daß der Emitteranschluß des ersten Transistors T1a mit dem Basisanschluß eines siebten Transistors T3b zusammengeschaltet ist und über einen Widerstand REa an den Kollektoranschluß des fünften Transistors TS geschaltet ist, daß der Emitteranschluß des zweiten Transistors T1b mit dem Basisanschluß eines achten Transistors T3a verbunden ist und über einen Widerstand PEb an den Kollektoranschluß des fünften Transistors TS geschaltet ist, daß der Emitteranschluß des dritten Transistors T2a an den Basisanschluß eines neunten Transistors T4a angeschlossen ist und über einen Widerstand REc an den Kollektoranschluß des sechsten Transistors TH geschaltet ist, daß der vierte Transistor T2b mit dem Basisanschluß eines zehnten Transistors T4b verbunden ist und über einen Widerstand REd an den Kollektoranschluß des sechsten Transistors TH geschaltet ist und daß die Emitteranschlüsse des siebten und des achten Transistors T3b, T3a über je einen Widerstand REg, REf an den Kollektoranschluß eines elf ten Transistors TS1 geschaltet sind, daß die Emitteranschlüsse des neunten und des zehnten Transistors T4a, T4b über je einen Widerstand REi, REk an den Kollektoranschluß eines zwölften Transistors TH1 geschaltet sind und daß die Kollektoranschlüsse des siebten, des achten, des neunten und des zehnten Transistors T3b, T3a, T4a, T4b jeweils über einen Widerstand RCg, RCf, RCi, RCk an das erste Versorgungspotential $V_{CC}$ geschaltet sind, daß die Emitteranschlüsse des elften und des zwölften Transistors TS1, TH1 gemeinsam über eine weitere Konstantstromeinprägung Ik2 an das zweite Versorgungspotential $V_{EE}$ geschaltet sind, daß der Steuereingang des elften Transistors TS1 mit dem Steuereingang des fünften Transistors TS zusammengeschaltet ist und, der Steuereingang des zwölften Transistors TH1 mit dem Steuereingang des sechsten Transistors TH zusammengeschaltet ist, daß zwischen dem ersten Versorgungspotential V$_{CC}$ und den Ausgangsklemmen Aa, Ab in Serie zum ersten und zum zweiten Kollektorwiderstand RCa, RCb jeweils eine Diode Da, Db in Durchlaßrichtung geschaltet ist und daß zwischen dem ersten Versorgungspotential V$_{CC}$ und den Kollektoranschlüssen des siebten, des achten, des neunten und des zehnten Transistors T3b, T3a, T4a und T4b jeweils eine Diode Dg, Df, Di, Dk in Durchlaßrichtung geschaltet ist.

Die prinzipielle Funktionsweise einer erfindungsgemäßen Abtast-Halte-Schaltungsanordnung mit kompensiertem Verstärker wird im folgenden anhand der Beschaltung des ersten Transistors T1a beschrieben. Der zweite, der dritte und der vierte Transistor T1b, T2a und T2b sind analog mit Hilfe des sechsten, des siebten und des achten Transistors T3b, T4a und T4b mit ihrer entsprechenden Beschaltung linearisiert.

Der Basisstrom, der dem ersten Transistor T1a zugeführt wird, wird durch den siebten Transistor T3b wieder abgeführt. Dadurch fließt sowohl im Kollektorwiderstand RCa als auch im Emitterwiderstand REa der gleiche Strom. Die Spannung über die Basis-Emitter-Diode des ersten Transistors T1a im Emitterkreis kann durch die erste Diode Da im Kollektorkreis ausgeglichen werden. Es ist empfehlenswert, daß die der Strom- und Spannungskompensation dienenden Transistoren einschließlich ihrer Emitter- und Kollektorkreisbeschaltung mit T3a, REf, RCf, T3b, REg, RCg, T4a, REi, RCi und T4b, REk, RCk und evtl. Dg, Df, Di und Dk identisch aufgebaut sind wie die Transistoren des eigentlichen Abtast-Halte-Verstärkers aus T1a, REa, RCa, T1b, RCb, REb, T2a, REc und T2b, REd und evtl. Da, und Db. Außerdem sollten die beiden Konstantstromeinprägungen Ik1 und Ik2 möglichst gleich sein. Die beschriebene erfindungsgemäße Schaltung ist dann in der Abtastphase, wenn der fünfte Transistor TS leitet, wenn also am Steuereingang ES des fünften Transistors ein höheres Potential anliegt als am Steuereingang EH des sechsten Transistors TH. In diesem Fall wird das Differenzsignal, das zwischen der Eingangsklemme Ea am Steuereingang des ersten Transistors T1a und der Eingangsklemme Ea am Steuereingang des zweiten Transistors T1b anliegt an die Ausgangsklemmen Aa und Ab geschaltet und über die Haltekapazität Ch gespeichert. Wenn am Steuereingang des sechsten Transistors TH ein höheres Potential ansteht als am Steuereingang des fünften Transistors TS, so sperrt der fünfte Transistor TS und die Stromeinprägung Ik1 wird auf den zweiten, den dritten, den neunten und den zehnten Transistor T2a, T2b, T4a, T4b umgeschaltet. In diesem Falle wird das über die Haltekapazität Ch gehaltenen Ausgangssignal über den dritten und vierten Transistor T2a und T2b an die Ausgangsklemme Aa und Ab geschaltet.

In monolithisch integrierter Technik werden Dioden üblicherweise als ensprechend beschaltete Transistoren realisiert. Will man die gleichen Strom- und Spannungsverhältnisse im Emitterund im Kollektorkreis einer erfindungsgemäßen Verstärkerschaltung realisieren, so sollten alle verwendeten Transistoren, auch die als Diode geschalteten, weitgehend identisch sein. Wenn die Dioden Da und Db als Transistor realisiert sind, dessen Basis- und Kollektoranschluß kurzgeschlossen und an das erste Versorgungspotential V$_{CC}$ angeschlossen sind, so fließt im Emitter dieser Transistoren jeweils sowohl der Kollektor- als auch der Basisstrom. Dieser Basisstrom kann jeweils, unabhängig von der Schalt stellung des Abtast-Halte-Verstärkers wieder abgezogen werden durch eine Schaltungsanordnung, wie sie in FIG 7 gezeigt wird, wobei als Diode Da, Db, Dg, Df, Di, Dk jeweils ein Transistor vorgesehen ist, wobei der Steuereingang des mit dem ersten und dem zweiten Kollektorwiderstand RCa, RCb in Serie geschalteten Transistors Da, Db jeweils gemeinsam mit dem Kollektoranschluß dieses Transistors an das erste Versorgungspotential V$_{CC}$ geschaltet ist, wobei der Steuereingang des in den Kollektorkreis des achten Transistors T3a und der Steuereingang des in den Kollektorkreis des neunten Transistors T4a geschalteten Transistors Df, Di an den zweiten Kollektorwiderstand RCb angeschlossenen Emitteranschluß des als Diode geschalteten Transistors Db angeschlossen ist, und wobei der Steuereingang des in den Kollektorkreis des siebten Transistors T3b und der Steuereingang des in den Kollektorkreis des zehnten Transistors T4b geschalteten Transistors Dg, Dk an den ersten Kollektorwiderstand RCa angeschlossenen Emitteranschluß des als Diode geschalteten Transistors Da geschaltet ist.

Da das Ausgangssignal des Abtast-Halte-Verstärkers in der Halte-Phase von dem Differenzsignal abhängt, das zwischen den Ausangsklemmen Aa und Ab liegt, hat ein gleichzeitiges Absinken des Signalpegels an beiden Ausgangsklemmen Aa und Ab um einen bestimmten Gleichspannungsanteil keinen Einfluß auf das Signal.

Wenn vorhergehend nur ein Teil der Gesamtschaltung beschrieben worden ist, so ist selbstverständlich, daß aufgrund des symmetrischen Aufbaus, dies jeweils auch für die andere Hälfte der Gesamtschaltung gilt. Aufgrund der Symmetrie korrespondierende Schaltungselemente unterscheiden sich in ihren Bezugszeichen hierbei durch die Buchstaben a und b. Eine Realisierung einer derartigen erfindungsgemäßen Abtast-Halte-Schaltungsanordnung ist sowohl mit Transistoren verschiedenster Typen, z.B. mit bipolaren Transistoren, MOSFETs, MISFETs oder MESFETs als auch in verschiedenen Technologien, z.B. in Si-, GaAs-Technologie oder anderen möglich.

**Ansprüche**

1. Schaltungsanordnung mit einem symmetrisch aufgebauten Abtast-Halte-Verstärker (AHV), bestehend aus einem ersten Transistor (T1a), einem zweiten Transistor (T1b), einem dritten Transistor (T2a) und einem vierten Transistor (T2b), wobei der Kollektor des ersten Transistors (T1a) mit dem Kollektor des dritten Transistors (T2a) zusammengeschaltet ist und die erste Ausgangsklemme (Aa) bildet und der Kollektor des zweiten Transistors (T1b) mit dem Kollektor des vierten Transistors (T2b) zusammengeschaltet ist und die zweite Ausgangsklemme (Ab) bildet, wobei die erste Ausgangsklemme (Aa) über einen ersten Kollektorwiderstand (RCa) an ein erstes Versorgungspotential (V$_{CC}$) geschaltet ist und die zweite Ausgangsklemme (Ab) über einen zweiten Kollektorwiderstand (RCb) ebenfalls an dieses erste Versorgungspotential (V$_{CC}$) geschaltet ist, wobei die erste Ausgangsklemme (Aa) mit den Steuereingang des vierten Transistors (T2b) verbunden ist und die zweite Ausgangsklemme (Ab) mit dem Steuereingang des dritten Transistors (T2a) verbunden ist, wobei der Steuereingang des ersten Transistors (T1a) eine erste Eingangsklemme (Ea) der Abtast-Halte-Schaltungsanordnung bildet, wobei der Steuereingang des zweiten Transistors (T1b) eine zweite Eingangsklemme (Eb) der Abtast-Halte-Schaltungsanordnung bildet, und diese beiden Klemmen (Ea, Eb) mit einem differenziellen Signal beaufschlagbar sind, wobei die erste und die zweite Ausgangsklemme (Aa, Ab) über eine Haltekapazität (Ch) miteinander verbunden sind, wobei die Emitter des ersten und des zweiten Transistors (T1a, T1b) und die Emitter des dritten und des vierten Transistors (T2a, T2b) jeweils über mindestens einen Widerstand (REa, REb bzw. REc, REd) miteinander verbunden sind, wobei der Emitterkreis des ersten Transistors (T1a) und der Emitterkreis des zweiten Transistors (T1b) gemeinsam an den Kollektoranschluß eines fünften Transistors (TS) geschaltet sind und der Emitterkreis des dritten Transistors (T2a) sowie der Emitterkreis des vierten Transistors (T2b) gemeinsam an den Kollektoranschluß eines sechsten Transistors (TH) geschaltet sind, wobei der Emitteranschluß des fünften Transistors (TS) gemeinsam mit dem Emitter anschluß des sechsten Transistors (TH) über eine Konstantstromeinprägung (Ik1) an das zweite Versorgungspotential (V$_{EE}$) geschaltet ist und wobei der Steuereingang (ES) des fünften Transistors (TS) und der Steuereingang (EH) des sechsten Transistors (TH) derart mit einem Signal beaufschlagt sind, daß der fünfte und der sechste Transistor (TS), (TH) alternierend einen Strom leiten oder sperren,
**dadurch gekennzeichnet,**
daß der Emitteranschluß des ersten Transistors (T1a) mit dem Basisanschluß eines siebten Transistors (T3b) zusammengeschaltet ist und über einen Widerstand (REa) an den Kollektoranschluß des fünften Transistors (TS) geschaltet ist, daß der Emitteranschluß des zweiten Transistors (T1b) mit dem Basisanschluß eines achten Transistors (T3a) verbunden ist und über einen Widerstand (REb) an den Kollektoranschluß des fünften Transistors (TS) geschaltet ist, daß der Emitteranschluß des dritten Transistors (T2a) an den Basisanschluß eines neunten Transistors (T4a) geschlossen ist und über einen Widerstand (REc) an den Kollektoranschluß des sechsten Transistors (TH) geschaltet ist, daß der vierte Transistor (T2b) mit dem Basisanschluß eines zehnten Transistors (T4b) verbunden ist und über einen Widerstand (REd) an den Kollektoranschluß des sechsten Transistors (TH) geschaltet ist, daß die Emitteranschlüsse des siebten und des achten Transistors (T3b, T3a) über je einen Widerstand (REg, REf) an den Kollektoranschluß eines elften Transistors (TS1) geschaltet sind, daß die Emitteranschlüsse des neunten und des zehnten Transistors (T4a, T4b) über je einen Widerstand (REi, REk) an den Kollektoranschluß eines zwölften Transistors (TH1) geschaltet sind, daß die Emitteranschlüsse des elften und des zwölften Transistors (TS1, TH1) gemeinsam über eine weitere Konstantstromeinprägung (Ik2) an das zweite Versorgungspotential (V$_{EE}$) geschaltet sind, daß der Steuereingang des elften Transistors (TS1) mit dem Steuereingang des fünften Transistors (TS) zusammengeschaltet ist und, der Steuereingang des zwölften Transistors (TH1) mit dem Steuereingang des sechsten Transistors (TH) zusammengeschaltet ist, daß die Kollektoranschlüsse des siebten, des achten, des neunten und des zehnten Transistors (T3b, T3a, T4a, T4b) jeweils über einen Widerstand (RCg, RCf, RCi, RCk) an das erste Versorgungspotential (V$_{CC}$) geschaltet sind.

2. Schaltungsanordnung nach Anspruch 1,
**dadurch gekennzeichnet,** daß zwischen dem ersten Versorgungspotential (V$_{CC}$) und den Ausgangsklemmen (Aa, Ab) in Serie zum ersten und zum zweiten Kollektorwiderstand (RCa, RCb) jeweils eine Diode (Da, Db) in Durchlaßrichtung geschaltet ist.

3. Schaltungsanordnung nach einem der vorhergehenden Ansprüche,
**dadurch gekennzeichnet,**
daß zwischen dem ersten Versorgungspotential (V$_{CC}$) und den Kollektoranschlüssen des siebten, des achten, des neunten und des zehnten Transistors (T3b, T3a, T4a und T4b) jeweils eine Diode (Dg, Df, Di, Dk) in Durchlaßrichtung geschaltet ist.

4. Schaltungsanordnung nach Anspruch 2 und 3,

**dadurch gekennzeichnet,**

daß als Diode (Da, Db, Dg, Df, Di, Dk) jeweils ein Transistor vorgesehen ist, daß der Steuereingang des mit dem ersten und dem zweiten Kollektorwiderstand (RCa, RCb) in Serie geschalteten Transistors (Da, Db) jeweils gemeinsam mit dem Kollektoranschluß dieses Transistors an das erste Versorgungspotential (V$_{CC}$) geschaltet ist, daß der Steuereingang des in den Kollektorkreis des achten Transistors (T3a) und der Steuereingang des in den Kollektorkreis des neunten Transistors (T4a) geschalteten Transistors (Df, Di) an den zweiten Kollektorwiderstand (RCb) angeschlossenen Emitteranschluß des als Diode geschalteten Transistors (Db) angeschlossen ist, und daß der Steuereingang des in den Kollektorkreis des siebten Transistors (T3b) und der Steuereingang des in den Kollektorkreis des zehnten Transistors (T4b) geschalteten Transistors (Dg, Dk) an den ersten Kollektorwiderstand (RCa) angeschlossenen Emitteranschluß des als Diode geschalteten Transistors (Da) geschaltet ist.

FIG 1

FIG 2

FIG 3

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 643 110 (THOMPSON) <br> * Spalte 3, Zeile 11 - Spalte 7, Zeile 29; Figuren 1-9 * <br> --- | 1 | G 11 C 27/02 |
| A | US-A-3 474 259 (RODGERS) <br> * Spalte 2, Zeile 30 - Spalte 6, Zeile 58; Figuren 1,2 * <br> --- | 1 | |
| A | EP-A-0 144 759 (TOSHIBA) <br> * Seite 5, Zeile 20 - Seite 9, Zeile 22; Figuren 3-5 * <br> --- | 1 | |
| A | DE-A-3 236 728 (TEXAS) <br> * Seite 7, Zeile 1 - Seite 14, Zeile 7; Figur 1 * <br> ----- | 1 | |

RECHERCHIERTE SACHGEBIETE (Int. Cl.5)

G 11 C 27/00
H 03 F 1/00

Der vorliegende Recherchenbericht wurde für alle Patentansprüche erstellt

| Recherchenort | Abschlußdatum der Recherche | Prüfer |
|---|---|---|
| DEN HAAG | 18-12-1989 | GEOGHEGAN C.H.B. |